# EUROPÄISCHE PATENTSCHRIFT

(11) **EP 1 310 319 B1**
(45) Veröffentlichungstag und Bekanntmachung des Hinweises auf die Patenterteilung: **06.09.2006**
(21) Anmeldenummer: 01126621.0
(22) Anmeldetag: 07.11.2001
(51) Int. Cl.: B23K 20/00, B23K 31/12, G01N 19/04, H01L 21/66

(54) **Prüfverfahren für Bondverbindungen und Drahtbonder**
Wire bonder and testing method for wire bonds
Appareil de microcablage et méthode de test

(43) Veröffentlichungstag der Anmeldung: 14.05.2003
(73) Patentinhaber: F & K Delvotec Bondtechnik GmbH, 85521 Ottobrunn (DE)
(72) Erfinder: Farassat, Farhad, Dr., 82024 Taufkirchen (DE)
(74) Vertreter: Heinze, Ekkehard

(56) Entgegenhaltungen:
- US-A- 4 854 494
- US-A- 5 230 458
- US-A- 5 591 920
- US-A- 5 894 981
- US-B1- 6 237 833

## Beschreibung

Die Erfindung betrifft ein Prüfverfahren für Drahtbondverbindungen sowie einen Drahtbonder, der mit einer entsprechenden integrierten Prüfanordnung ausgestattet ist.

Das Drahtbonden ist ein Verfahren, bei dem elektrische Verbindungen von Halbleiterbauteilen mittels feiner Metalldrähte hergestellt werden. Mit Drahtbondverbindungen können beispielsweise elektrische Verbindungen zwischen Kontaktflächen diskreter Bauelemente oder integrierter Schaltkreise und Kontaktflächen der zugehörigen Gehäuse oder, bei Hybridschaltungen, Verbindungen zwischen eingesetzten monolithischen Elementen und der Dickschicht-Schaltung hergestellt werden, in die diese eingesetzt sind.

Im Zuge der Entwicklung der Anschlußtechnologie für Halbleiterbauelemente und -schaltkreise sind verschiedene Bondverfahren entwickelt und eine Vielzahl von hierfür geeigneten Bondmaschinen vorgeschlagen worden. Die gebräuchlichsten Drahtbondverfahren sind das Ultraschallbonden (U/S bonding), das Thermokompressionsbonden (T/C bonding) und das Thermoschallbonden (T/S bonding). Drahtbonder zur Durchführung dieser Verfahren führen einen Bonddraht zu dem für die Erzeugung der Bondverbindung vorgesehenen Punkt (Bondpad), und dann wird der Draht mittels eines Bondwerkzeugs, etwa in Gestalt einer Kapillare, eines Keils oder eines Nagelkopfes, dort unter Anwendung einer Druckkraft sowie zusätzlicher Einwirkung von Schwingungs- und/oder Wärmeenergie unter Deformierung befestigt. Hierbei bildet sich eine Art Schweißverbindung zwischen dem Bonddraht und dem Bondpad.

Die Qualität der Bondverbindung ist entscheidend für die Funktionsfähigkeit und Zuverlässigkeit der unter Einsatz des Bondverfahrens gebildeten elektronischen Komponente. Daher ist einerseits eine Überwachung der Parameter des Bondvorganges und andererseits eine Qualitätsprüfung der erzeugten Bondverbindung wünschenswert, wenn nicht unverzichtbar. Es sind daher verschiedene Lösungen zur Erfassung und Regelung von wesentlichen Parametern des Bondvorganges - insbesondere der Bondkraft und ggf. zusätzlich der Ultraschallamplitude bzw. -energie - während des Bearbeitungsvorganges vorgeschlagen worden.

In der US 4,854,494 wird ein Drahtbonder mit Mitteln zur Überwachung mehrerer Bondparameter, und zwar speziell der Bondkraft und Ultraschallamplitude, beschrieben. Dieser Drahtbonder hat einen Werkzeughalter mit einem Schwächungsabschnitt, in dem beim Aufdrücken des Bonddrahtes auf das Bondpad mittels des Werkzeuges eine Biegung auftreten kann. Über einen in diesem Schwächungsabschnitt angeordneten Dehnungsmeßstreifen wird die momentane Bondkraft erfaßt und kann über eine nachgeschaltete Regelung auf einem vorbestimmtem Sollwert gehalten werden.

In der US 5,230,458 wird ebenfalls ein Bondkopf mit einem Kraftsensor beschrieben, der die durch das Bondwerkzeug ausgeübte Druckkraft mißt und einer Echtzeit-Regelschaltung zuführt. Diese gibt ein Stellsignal an einen eine Bewegung in Z-Richtung bewirkenden Aktuator zur Einstellung der Bondkraft aus. Bei der hier beschriebenen Bondmaschine handelt es sich um einen Ultraschallbonder vom Kapillartyp, bei dem der Ultraschallwandler mit der daran angebrachten Kapillare als Bondwerkzeug an einem Tragrahmen angebracht ist. Dieser trägt auch einen Ausleger zur Führung des Bonddrahtes, welcher oberhalb eines weiteren Auslegers mit dem Ultraschallwandler angeordnet ist.

In der GB 2 270 868 A der Anmelderin wird ein Drahtbondverfahren und -system vom Typ des Ultraschall-Keil-Bonders (U/S wedge bonder) beschrieben, bei dem ebenfalls eine Erfassung und kontinuierliche Regelung von Bondkraft und Ultraschallenergie vorgesehen ist. Zu diesem Zweck wird die Deformation des Bonddrahtes überwacht.

In der EP 0 857 535 A1 der Anmelderin wird ein Bondkopf mit zwei Auslegern beschrieben, von denen der erste (Werkzeughalter) das Bondwerkzeug und der zweite, oberhalb angeordnete, (Drahtklemmenhalter) eine Drahtklemme zum Erfassen und Fixieren eines Bonddrahtes trägt. Auch hier handelt es sich um einen Bonder vom Ultraschall-Keil-Typ. Die Bondkraft wird im Zusammenwirken eines Linearmotors mit einer Vorspannfeder aufgrund des Signals eines am Ende des Werkzeughalters angeordneten Piezodetektors eingestellt.

Darüber hinaus ist es bekannt, zur Prüfung von Bondverbindungen eine Zugkraft mit einem vorbestimmten Wert auf den befestigten Bonddraht auszuüben. Widersteht die Bondverbindung dieser Zugkraft, wird sie als qualitativ einwandfrei beurteilt. Diese Prüfung wird als dem Herstellungsvorgang nachgeschalteter Prüfvorgang ausgeführt.

Ein Prüfverfahren nach dem Oberbegriff des Anspruchs 1 und ein Drahtbonder nach dem Oberbegriff des Ansprüchs 4 sind aus US 5 591 920 A bekannt.

Der Erfindung liegt die Aufgabe zugrunde, ein unmittelbar in den Herstellungsprozeß integriertes Prüfverfahren für Bondverbindungen sowie einen zur Durchführung dieses Verfahrens geeigneten Drahtbonder anzugeben, welche eine Echtzeit-Qualitätskontrolle und die sofortige Ausführung von qualitätssichernden Einstellvorgängen beim laufenden Bondprozeß ermöglichen.

Diese Aufgabe wird in ihrem Verfahrensaspekt durch ein Prüfverfahren mit den Merkmalen des Anspruchs 1 und in ihrem Vorrichtungsaspekt durch einen Drahtbonder mit den Merkmalen des Anspruchs 4 gelöst.

Die Erfindung schließt den wesentlichen Gedanken ein, eine Bondverbindung unmittelbar nach deren Herstellung einer Zugkraft auszusetzen und das Ansprechen zu erfassen. Sie schließt weiter den Gedanken ein, hierzu eine geeignete Schrittfolge von Bewegungen des Bondwerkzeuges sowie einer Drahtklemme zum Erfassen des Bonddrahtes in Verbindung mit einem Zugkraft-Erfassungsschritt sowie eine entsprechende Anordnung eines Werkzeughalters sowie eines Drahtklemmenhalters in Verbindung mit einer angepaßten Steuer- und Auswertungseinrichtung anzugeben. Wesentliches Merkmal der Verfahrensführung ist das feste Ergreifen und Anziehen des Bonddrahtes unmittelbar nach Erzeugung der Bondverbindung (jedoch nach Aufhebung des Kontaktes derselben mit dem Bondwerkzeug) bei gleichzeitiger Zugkrafterfassung.

Insbesondere wird der Bondkopf oder die Drahtklemme um eine in Abhängigkeit von den Konstruktionsmerkmalen derart berechnete zweite Strecke angehoben, daß durch das Anheben eine vorbestimmte oder programmierte Zugkraft erzeugt wird, und die Unversehrtheit der Bondverbindung beim Anheben erfaßt. Diese wird durch die Überwachung der Zeitabhängigkeit der an der Drahtklemme wirkenden Zugkraft während des Anhebens festgestellt. Ein Abreißen der Bondverbindung bei Anwendung der Prüfkraft würde zu einem schlagartigen Abfall der gemessenen Kraft führen, und auch geringfügigere Anomalitäten im zeitlichen Verlauf der gemessenen Zugkraft können auf Qualitätsmängel der Bondverbindung hinweisen und - im Ergebnis einer entsprechenden Auswertung - Anlaß zu Änderungen von Prozeßparametern geben.

Eine zur Realisierung der vorgeschlagenen Lösung geeignete Prüfanordnung umfaßt als wesentliches Element den (an sich bekannten) Drahtklemmenhalter mit einem zugeordneten Kraftmeßelement und eine Steuereinrichtung zur Steuerung des oben skizzierten Bewegungsablaufes und stellt eine integrierte Komponente eines verbesserten Drahtbonders dar.

Erfindungsgemäß ist der Drahtklemmenhalter gegen ein Vorspannelement elastisch schwenkoder verschiebbar am Bondkopf gelagert ist. Ihm ist ein Kraftmeßelement, insbesondere ein Dehnungsmeßstreifen, zugeordnet. Bevorzugt hat er einen geschwächten Abschnitt, in dem die durch die Antriebseinrichtung gelieferte Zugkraft eine ausgeprägte elastische Deformation (Verbiegung, Verdrehung oder Dehnung) des Halters bewirkt. Dort ist insbesondere auch das Kraftmeßelement (speziell der Dehnungsmeßstreifen) angeordnet, um ein einwandfrei auswertbares Kraftmeßsignal zu gewinnen.

Die erwähnte Steuereinrichtung ist zur sinnvollen Integration der Prüfanordnung in eine moderne Drahtbondmaschine als Programmsteuerung ausgeführt und erlaubt die automatische Durchführung des Prüfprogramms an sämtlichen oder ausgewählten Bondverbindungen, die mit dem Drahtbonder hergestellt werden.

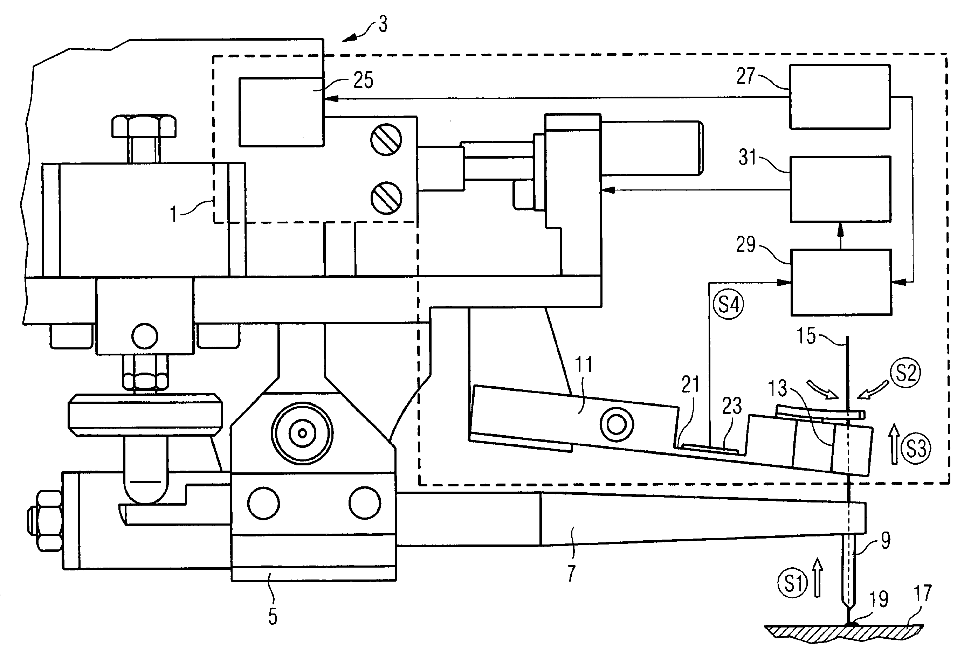

Vorteile und Zweckmäßigkeiten der Erfindung ergeben sich im übrigen aus den Unteransprüchen sowie der nachfolgenden Beschreibung eines bevorzugten Ausführungsbeispiels anhand der Figur. Diese zeigt in einer schematischen Darstellung eine Prüfanordnung 1 mit wesentlichen Komponenten des Bondkopfes 3 eines erfindungsgemäß gestalteten Ultraschall-Drahtbonders. Die Prinzipdarstellung bezieht sich auf einen Bondkopf der in der EP 0 857 535 A1 dargestellten Art, dessen Konstruktionsdetails hier aber nicht gezeigt sind. In Art einer synoptischen Darstellung sind Funktionsblöcke mit Auswertungs- und Steuerfunktionen und Symbole für die wesentlichen Verfahrensschritte hinzugefügt.

Der Bondkopf 3 umfaßt einen Transducerhalter 5, in dem ein Ausleger mit einem Ultraschallwandler (Transducer) 7 und einem daran befestigten Bondwerkzeug 9 (z. B. vom Kapillar- oder Wedge-Typ) gelagert ist, und einen Drahtklemmenhalter 11, der eine Drahtklemme 13 zum gesteuerten Festklemmen eines Bonddrahtes 15 trägt. Der Bondkopf erzeugt auf einem Substrat 17 auf an sich bekannte Weise eine Bondverbindung 19, deren Festigkeit mittels der Prüfanordnung 1 geprüft werden soll.

Der Drahtklemmenhalter 11 hat in einem mittleren Bereich seiner Längserstreckung einen Blattfederabschnitt 21 als Vorzugs-Biegeabschnitt, in dem ein Dehnungsmeßstreifen 23 oder ähnlich auf Biegeverformungen ansprechender Kraftsensor angebracht ist.

Eine (hier zur Vereinfachung als einzelner Block dargestellte) Antriebseinrichtung 25 des Bondkopfes 3 steuert den Bondkopf bzw. als separat bewegbare Komponenten den Werkzeughalter 5 und den zugehörigen Ausleger mit dem Transducer 7 sowie den Drahtklemmenhalter 11 und die Drahtklemme 13 nicht nur in an sich bekannter Weise zur Erzeugung der Bondverbindung 19, sondern überdies gemäß einem in einer Programmspeichereinheit 27 gespeicherten Prüfprogramm der weiter oben beschriebenen Art an. Hierdurch werden insbesondere ein erster Schritt S1 des geringfügigen Anhebens des Bondwerkzeuges 9 gegenüber der erzeugten Bondverbindung 19, ein Schritt S2 des Festklemmens des Bonddrahtes 15, ein Schritt S3 des Anhebens der Drahtklemme 13 mit dem eingeklemmten Bonddraht 15 und ein Schritt S4 der Erfassung eines beim Anheben erfaßten Ausgangswertes des Dehnungsmeßstreifens 23 gesteuert.

Der Dehnungsmeßstreifen 23 ist mit einer Zugkraft-Auswertungseinheit 29 verbunden, und sein Ausgangssignal wird dort einer Auswertung nach einem vorbestimmten Algorithmus - beispielsweise unter Einschluß einer Schwellwertdiskriminierung an einem Zugkraft-Minimalwert - unterzogen. Ausgangsseitig ist die Zugkraft-Auswertungseinheit 29 mit einer Bondparameter-Steuereinheit 31 verbunden, in der das Auswertungsergebnis gegebenenfalls in vorbestimmte Änderungen der Bondparameter zur Sicherung der Qualität der Bondverbindung 19 umgesetzt wird.

Die Ausführung der Erfindung ist nicht auf das oben beschriebene Beispiel beschränkt, sondern ebenso in einer Vielzahl von Abwandlungen möglich, die im Rahmen der folgenden Ansprüche liegen.

### Bezugszeichenliste

- 1: Prüfanordnung
- 3: Bondkopf
- 5: Transducerhalter
- 7: Transducer
- 9: Bondwerkzeug
- 11: Drahtklemmenhalter
- 13: Drahtklemme
- 15: Bonddraht
- 17: Substrat
- 19: Bondverbindung
- 21: Blattfederabschnitt
- 23: Dehnungsmeßstreifen
- 25: Antriebseinrichtung
- 27: Programmspeichereinheit
- 29: Zugkraft-Auswertungseinheit
- 31: Bondparameter-Steuereinheit

## Patentansprüche

1. Prüfverfahren für Drahtbondverbindungen zwischen einem Bonddraht und einer gesonderten Oberfläche, die durch einen Bondkopf mit einem Bondwerkzeug und einer dem Bondwerkzeug zugeordneten Drahtklemme unter Druck und Einwirkung von Ultraschall und/oder Wärme hergestellt wurde,
wobei
nach Erzeugung der Bondverbindung der Bondkopf oder das Bondwerkzeug um eine kurze erste Strecke von der Bondstelle abgehoben,
der Bonddraht mit der Drahtklemme fest eingeklemmt und
der Bondkopf oder die Drahtklemme mit eingeklemmtem Bonddraht um eine zweite Strecke angehoben wird, **dadurch gekennzeichnet, dass** mit einem auf Biegeverfarmüngen ansprechender Kraftsensor die auf den Bonddraht einwirkende Zugkraft erfaßt wird.

2. Prüfverfahren nach Anspruch 1,
**dadurch gekennzeichnet, daß**
der Bondkopf oder die Drahtklemme um eine in Abhängigkeit von seinen Konstruktionsmerkmalen derart berechnete zweite Strecke angehoben wird, daß durch das Anheben eine vorbestimmte Zugkraft erzeugt wird, und
eine Unversehrtheit der Bondverbindung beim Anheben erfaßt wird.

3. Prüfverfahren nach Anspruch 2,
**dadurch gekennzeichnet, daß**
die Unversehrtheit der Bondverbindung durch die Überwachung der Zeitabhängigkeit der an der Drahtklemme wirkenden Zugkraft während des Anhebens festgestellt wird.

4. Drahtbonder mit einer in einen Bondkopf integrierten Prüfanordnung für Drahtbondverbindungen zwischen einem Bonddraht und einer gesonderten Oberfläche, insbesondere einem Bondpad, mit einem Bondkopf, welcher einen Werkzeug- bzw. Transducerhalter zum Halten eines Bondwerkzeuges und einen Drahtklemmenhalter zum Halten e ner Drahtklemme zum Einklemmen eines Bonddrahtes sowie e ne Antriebseinrichtung zum vertikalen Verfahren des Bond kopfes oder Werkzeughalters und Drahtklemmenhalters aufweist, wobei
der Antriebseinrichtung eine Programmsteuereinrichtung zur Steuerung eines vorbestimmten Bewegungsablaufes des Bondkopfes oder Werkzeughalters und Drahtklemmenhalters zur Ausführung einer Zugkraftmessung am Bonddraht und
dem Drahtklemmenhalter eine Kraftmeßeinrichtung zum Messen einer auf eine mit dem Bonddraht erzeugte Bondverbindung einwirkende Zugkraft zugeordnet ist,
**dadurch gekennzeichnet, daß**
der Drahtklemmenhalter gegen ein Vorspannelement elastisch schwenk- oder verschiebbar am Bondkopf gelagert ist und ihm ein auf Biegeverfarmungen ansprechender Kraftsensor zugeordnet ist.

5. Drahtbonder nach Anspruch 4,
**dadurch gekennzeichnet, daß**
der Drahtklemmenhalter einen geschwächten Vorzugs-Biegeabschnitt bzw. Blattfederabschnitt aufweist, der die elastische Schwenkbarkeit gewährleistet und in dem der Dehnungsmeßstreifen angeordnet ist.

6. Drahtbonder nach Anspruch 4 oder 5,
**dadurch gekennzeichnet, daß**
in der Programmsteuereinrichtung ein Steuerprogramm zur automatischen Durchführung des Verfahrens nach einem der Ansprüche 1 bis 3 implementiert ist.

## Claims

1. Testing method for wire bond connections between a bonding wire and a separate surface produced by a bonding head with a bonding tool and with a wire clamp associated with the bonding tool, using pressure and the application of ultrasound and/or heat, the bonding head or bonding tool being raised by a first, short distance from the bond location after production of the bond connection, the bonding wire being firmly gripped by the wire clamp and the bonding head or wire clamp with the gripped bonding wire being raised by a second distance, **characterised in that** the tensile force acting on the bonding wire is ascertained using a force sensor which responds to bending strain.

2. Testing method according to claim 1,
**characterised in that**
the bonding head or wire clamp is raised by a second distance which is so calculated in dependence on its constructional features that a predetermined tensile force is produced as a result of the raising, and integrity of the bond connection is ascertained on raising.

3. Testing method according to claim 2,
**characterised in that**
the integrity of the bond connection is established by monitoring the time dependence of the tensile force acting at the wire clamp during raising.

4. Wire bonder comprising, integrated into a bonding head, a testing arrangement for wire bond connections between a bonding wire and a separate surface, especially a bond pad, comprising a bonding head which has, for holding a bonding tool, a tool holder or transducer holder and, for holding a wire clamp for gripping a bonding wire, a wire clamp holder, and also a drive device for vertical movement of the bonding head or tool holder and wire clamp holder, there being associated with the drive device a program control device for controlling a predetermined movement sequence of the bonding head or tool holder and wire clamp holder for performing a tensile force measurement on the bonding wire and there being associated with the wire clamp holder a force-measuring device for measurement of a tensile force acting on a bond connection produced using the bonding wire,
**characterised in that**
the wire clamp holder is mounted on the bonding head so as to be resiliently pivotable or displaceable with respect to a biasing element and a force sensor which responds to bending strain is associated therewith.

5. Wire bonder according to claim 4,
**characterised in that**
the wire clamp holder has a weakened preferential bending portion or leaf spring portion, which ensures the resilient pivotability and in which the strain gauge is arranged.

6. Wire bonder according to claim 4 or 5,
**characterised in that**
in the program control device there is implemented a control program for automatic performance of the method according to one of claims 1 to 3.

## Revendications

1. Procédé de vérification de liaisons par fils entre un fil de liaison et une surface séparée, liaisons qui ont été établies sous pression et sous l'effet d'ultrasons et/ou de la chaleur, par une tête de liaison à l'aide d'un outil de liaison et d'une mâchoire à tendre les fils associée à l'outil de liaison, la tête de liaison ou l'outil de liaison, après la réalisation de la liaison, étant soulevé(e) du site de liaison sur une courte première distance, le fil de liaison étant fermement pincé par la mâchoire à tendre les fils, et la tête de liaison ou la mâchoire à tendre les fils dans laquelle est serré le fil de liaison étant soulevé(e) sur une deuxième distance, **caractérisé en ce que** la force de traction qui s'exerce sur le fil de liaison est détectée au moyen d'un capteur de force sensible aux déformations dues à la flexion.

2. Procédé de vérification selon la revendication 1, **caractérisé en ce que** la tête de liaison ou la mâchoire à tendre les fils est soulevée sur une deuxième distance qui est calculée, en fonction de ses caractéristiques de construction, de telle sorte qu'une force de traction prédéterminée soit produite du fait du soulèment, et **en ce que** l'intégrité de la liaison est détectée lors du soulèvement.

3. Procédé de vérification selon la revendication 2, **caractérisé en ce que** l'intégrité de la liaison est déterminée par surveillance de la dépendance du temps de la force de traction qui agit sur la mâchoire à tendre les fils, lors du soulèvement.

4. Dispositif de liaison par fil pourvu d'un dispositif de vérification, intégré dans une tête de liaison, de liaisons par fils entre un fil de liaison et une surface séparée, en particulier un coussinet de liaison, comprenant une tête de liaison présentant un support d'outil ou de transducteur, destiné à servir de support à un outil de liaison, et un support de mâchoire à tendre les fils destiné à servir de support à une mâchoire à tendre les fils servant à serrer un fil de liaison, ainsi qu'un dispositif d'entraînement afin de déplacer verticalement la tête de liaison ou le support d'outil et le support de mâchoire à tendre les fils,
un dispositif de commande à programme, destiné à commander un déroulement de mouvements prédéterminé de la tête de liaison ou du support d'outil et du support de mâchoire à tendre les fils étant associé au dispositif d'entraînement pour exécuter une mesure de la force de traction sur le fil de liaision et
un dispositif de mesure de force destiné à mesurer une force de traction s'exerçant sur une liaison par fil établie à l'aide du fil de liaison étant associé au support de mâchoire à tendre les fils
**caractérisé en ce que**
le support de mâchoire à tendre les fils est monté sur la tête de liaison avec possibilité de coulissement ou de déplacement élastique par rapport à un élément de précontrainte et **en ce qu'**un capteur de force sensible aux déformations dues à la flexion lui est associé.

5. Dispositif de liaison par fil selon la revendication 4, **caractérisé en ce que** le support de mâchoire à tendre les fils présente un tronçon de flexion préférentiel affaibli et/ou un tronçon comportant un ressort à lame, qui assure l'orientabilité élastique et dans lequel se situe la jauge d'allongement.

6. Dispositif de liaison par fil selon la revendication 4 ou 5, **caractérisé en ce qu'**est installé, dans le dispositif de commande à programme, un programme de commande permettant d'exécuter automatiquement le procédé selon l'une des revendications 1 à 3.
